# EUROPÄISCHE PATENTSCHRIFT

(11) **EP 4 798 979 B1**
(45) Veröffentlichungstag und Bekanntmachung des Hinweises auf die Patenterteilung: **07.10.2026**
(21) Anmeldenummer: 25713159.9
(22) Anmeldetag: 14.02.2025
(51) Int. Cl.: G01R 31/367, B60L 58/16, G01R 31/392, G01R 35/00

(54) **ALTERUNGSVERFAHREN FÜR EINE NUTZUNGSSPEZIFISCHE BESCHLEUNIGTE ALTERUNG VON BATTERIEZELLEN AUF EINEM PRÜFSTAND ZUR ERZEUGUNG VON KALIBRIERINFORMATIONEN**
AGING METHOD FOR AN ACCELERATED USE-SPECIFIC AGING OF BATTERY CELLS ON A TEST STAND IN ORDER TO GENERATE CALIBRATION INFORMATION
PROCÉDÉ DE VIEILLISSEMENT POUR PERMETTRE UN VIEILLISSEMENT ACCÉLÉRÉ SPÉCIFIQUE À L'UTILISATION D'ÉLÉMENTS DE BATTERIE SUR UN BANC D'ESSAI POUR GÉNÉRER DES INFORMATIONS D'ÉTALONNAGE

(30) Priorität: 15.02.2024 AT 501172024
(43) Veröffentlichungstag der Anmeldung: 02.09.2026
(73) Patentinhaber: AVL List GmbH, 8020 Graz (AT)
(72) Erfinder: PALLEWAR, Pankaj Ganeshrao, 8020 Graz (AT); ARAS KACAR, Ayse Cisel, 34340 Besiktas (TR); TURGUT, Furkan Metin, Warwickshire UK-CV32 7RJ (GB); SIVARAMAN, Thyagesh, 8054 Seiersberg-Pirka (AT); VOLCK, Marlena, 8077 Gössendorf (AT)
(86) Internationale Anmeldenummer: PCT/AT2025/060055
(87) Internationale Veröffentlichungsnummer: WO 2025/171426

(56) Entgegenhaltungen:
- EP-A1- 4 174 504
- CN-A- 109 870 659

## Beschreibung

Die vorliegende Erfindung betrifft ein Alterungsverfahren für ein nutzungsspezifische beschleunigte Alterung von Batteriezellen zur Erzeugung von Kalibrierinformationen, eine Alterungsvorrichtung zur Durchführung eines solchen Alterungsverfahrens sowie ein Computerprogrammprodukt zur Durchführung eines solchen Alterungsverfahrens.

Es ist bekannt, dass Alterungsverfahren eingesetzt werden, um beschleunigte Alterungstests für Batterievorrichtungen durchzuführen. Dies ist insbesondere dafür notwendig, um Batteriefahrzeuge entsprechend ihrer Dauerstabilität auszulegen und ausreichend dauerstabile Batterievorrichtungen einzusetzen. Hierfür werden üblicherweise komplette Batterievorrichtungen, welche eine Vielzahl von einzelnen, miteinander verschalteten Batteriezellen aufweisen, in Klimakammern eingesetzt und dort definierten Lade- und Entladezyklen unterzogen. Durch die Klimakammer ist es möglich, verschiedene Temperatursituationen einzustellen und vorzugeben, sodass durch die erhöhte Temperaturbelastung und definierte Lade- und Entladezyklen eine beschleunigte Belastung und damit eine beschleunigte Alterung der Batterievorrichtung erzielt werden kann. Das Ergebnis solcher bekannter Alterungsverfahren ist üblicherweise die Anzahl der Ladezyklen, welche möglich sind, bis ein maximaler Gesundheitszustand der Batterievorrichtung erreicht ist. Diese maximale Anzahl an Ladezyklen soll anschließend der beabsichtigten Kilometerleistung des jeweiligen Fahrzeugs entsprechen. Als Stand der Technik kann hier beispielweise das Dokument EP 4 174 504 A1 gesehen werden.

Nachteilhaft bei den bekannten Lösungen ist es, dass insbesondere keine nutzungsspezifische Alterung möglich ist. Zwar ist es grundsätzlich möglich, unterschiedliche Temperaturprofile einzustellen, also zum Beispiel zu unterscheiden, ob die Batterievorrichtung in heißen Klimaregionen der Erde oder in kalten Klimaregionen eingesetzt werden soll, jedoch können unterschiedliche Nutzungsarten, wie beispielsweise eine Rennstreckennutzung, eine Pendler-Nutzung, ein Kurzstreckenbetrieb oder Ähnliches in effizienter Weise simuliert werden.

Ein weiterer Nachteil der bekannten Lösungen ist es, dass als Ausgabe im Wesentlichen ausschließlich für die Qualitätsbestimmung die Anzahl der Ladezyklen bis zum Erreichen des reduzierten vordefinierten Gesundheitszustands der Batterievorrichtung enthält. Weitere Details, insbesondere Rückkopplungen und Nutzungen dieser Qualitätsinformationen für den tatsächlichen Einsatz der Batterievorrichtungen in einem Fahrzeug, sind bisher nicht möglich.

Es ist daher Aufgabe der vorliegenden Erfindung, die voranstehend beschriebenen Probleme zumindest teilweise zu beheben. Insbesondere ist es Aufgabe der vorliegenden Erfindung, in kostengünstiger und einfacher Weise eine Kalibrierung eines Batteriemanagementsystems eines Batteriefahrzeugs auf Basis von Alterungsinformationen durchzuführen.

Die voranstehende Aufgabe wird gelöst durch ein Alterungsverfahren mit den Merkmalen des Anspruchs 1, einer Alterungsvorrichtung mit den Merkmalen des Anspruchs 14 sowie ein Computerprogrammprodukt mit den Merkmalen des Anspruchs 15. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Alterungsverfahren beschrieben sind, selbstverständlich auch im Zusammenhang mit der erfindungsgemäßen Alterungsvorrichtung sowie dem erfindungsgemäßen Computerprogrammprodukt und jeweils umgekehrt, sodass bezüglich der Offenbarung zu den einzelnen Erfindungsaspekten stets wechselseitig Bezug genommen wird beziehungsweise werden kann.

Erfindungsgemäß dient ein Alterungsverfahren dazu, eine nutzungsspezifische beschleunigte Alterung von Batteriezellen auf einem Prüfstand durchzuführen für eine Erzeugung von Kalibrierinformationen. Ein solches Alterungsverfahren zeichnet sich durch die folgenden Schritte aus:
- Elektrisches Anschließen wenigstens einer Batteriezelle an einer Alterungsvorrichtung,
- Durchführen einer Referenzierung zur Bestimmung eines Ist-SoH (State of Health) an der angeschlossenen Batteriezelle,
- Durchführen einer ersten Alterungsschleife, aufweisend
   ∘ einen ersten Alterungsprozess, welcher für eine erste Alterungsart der angeschlossenen Batteriezelle spezifisch ist, mit anschließender Referenzierung zur Bestimmung des Ist-SoH der angeschlossenen Batteriezelle nach dem ersten Alterungsprozess,
   ∘ Vergleich des bestimmten Ist-SoH mit einem ersten Alterungsgrenzwert und Wiederholen des ersten Alterungsprozesses und der Referenzierung bis der bestimmte SoH den ersten Alterungsgrenzwert unterschreitet,
- Durchführen einer zweiten Alterungsschleife aufweisend
   ∘ einen zweiten Alterungsprozess, welcher für eine zweite Alterungsart der angeschlossenen Batteriezelle spezifisch ist, welche sich von der ersten Alterungsart unterscheidet, mit anschließender Referenzierung zur Bestimmung des Ist-SoH der angeschlossenen Batteriezelle nach dem zweiten Alterungsprozess,
   ∘ Vergleich des bestimmten Ist-SoH mit einem zweiten Alterungsgrenzwert und Wiederholen des zweiten Alterungsprozess und der Referenzierung bis der bestimmte Ist-SoH den zweiten Alterungsgrenzwert unterschreitet,
- Ausgeben von Kalibrierinformationen, welche zu wenigstens einige der bestimmten Ist-SoH zugehörigen Messwerte der angeschlossenen Batteriezelle enthalten zur Nutzung in einer Kontrollvorrichtung eines Fahrzeugs.

Ein erfindungsgemäßes Alterungsverfahren dient dazu, Kalibrierinformationen zu erzeugen, welche mit definierter Alterung einer einzelnen oder mehrerer Batteriezellen im Zusammenhang steht. So ist ein Kernunterschied der vorliegenden Erfindung zu den bekannten Lösungen, dass nicht eine komplette Batterievorrichtung behandelt wird, sondern eine einzelne Batteriezelle. Selbstverständlich können, wie dies später noch erläutert wird, auch mehrere Batteriezellen in paralleler Weise einem identischen oder unterschiedlichen Alterungsverfahren unterzogen werden.

Diese Batteriezelle wird nach dem elektrischen Anschluss an eine Alterungsvorrichtung nun in einem ersten Schritt referenziert. Ein Referenzieren bezieht sich darauf, dass eine Referenzsituation erkannt und definiert wird. Referenziert wird auf den sogenannten State of Health (SoH). Dieser State of Health ist insbesondere ein physikalischer Parameter und kann zum Beispiel die verbleibende Restkapazität, der Innenwiderstand oder eine andere elektrische Information der angeschlossenen Batteriezellen sein. Üblicherweise handelt es sich um die Restkapazität, sodass bei einer definierten Nennkapazität von 100% der angeschlossenen Batteriezelle eine Alterung dahingehend erkennbar wird, dass nur noch ein verringerter Prozentsatz von beispielsweise 95%, 90%, 80% oder weniger als Restkapazität zur Verfügung steht.

Erfindungsgemäß wird nun im ersten Schritt referenziert, um den Ausgangspunkt, also die 100% oder Nennkapazität der angeschlossenen Batteriezelle, zu erkennen und als Ausgangspunkt für die daran anschließende gezielte Alterung festzulegen. Anschließend folgen im Wesentlichen zumindest zwei Alterungsschleifen. Selbstverständlich ist es grundsätzlich auch im Rahmen der vorliegenden Erfindung möglich, zwei, drei, vier oder mehr Alterungsschleifen mit ähnlichen oder unterschiedlichen Alterungsprozessen durchzuführen. Der erfindungsgemäße Hauptvorteil wird jedoch bereits mit zumindest zwei Alterungsschleifen erzielt. Die beiden Alterungsschleifen unterscheiden sich voneinander dadurch, dass unterschiedliche Alterungsprozesse durchgeführt werden.

Ein Alterungsprozess im Sinne der vorliegenden Erfindung zeichnet sich dadurch aus, dass verschiedene Rahmenparameter vorgegeben und/oder eingehalten werden, um diese Alterungsart zu erreichen. Solche Rahmenparameter werden später noch näher erläutert und beinhalten zum Beispiel Laderaten, Entladeraten, das Erreichen unterschiedlicher Ladungszustände, das Einhalten bestimmter Temperaturfenster oder Ähnliches. Hier wird bereits ersichtlich, dass es nicht darum geht immer volle Ladezyklen zu fahren, sondern es auch möglich ist beispielsweise auch kurzfristige Zwischenladungen in einem solchen Alterungsprozess einzugliedern. Da für die Kalibrierinformationen später nicht mehr die gesamte Zahl der Ladezyklen nachgehalten werden muss, besteht hier somit eine größere Freiheit, die einzelnen Alterungsprozesse viel näher an die tatsächliche Nutzungsart und die tatsächliche Alterungsart anzupassen. Die Alterungsschleifen unterscheiden sich dadurch voneinander, dass die Alterungsprozesse unterschiedlich ausgebildet sind. So können die Alterungsprozesse beispielsweise zu unterschiedlichen Temperaturen mit unterschiedlichen Laderaten, mit unterschiedlichen Wiederholungsraten oder ähnlichen, sich unterscheidenden Parametern durchgeführt werden.

Ein weiterer Kerngedanke der vorliegenden Erfindung beruht darauf, dass innerhalb jeder Alterungsschleife auch eine Referenzierung stattfindet. Diese Referenzierung kann nach jedem durchgeführten Alterungsprozess oder auch nach mehreren Alterungsprozessen erfolgen. Mit anderen Worten wird über das gesamte Verfahren nicht nur zu Beginn und zum Ende, sondern auch zu definierten Zwischensituationen, eine Referenzierung durchgeführt, sodass über den Verlauf des Alterungsverfahrens der sich mit der Alterung entwickelnde jeweils aktuelle State of Health und damit der Gesundheitszustand der zu alternden angeschlossenen Batteriezelle jeweils bekannt ist und auch bestimmt wird. Es ist also möglich, in kontrollierter und überwachter Weise das Alterungsverfahren so durchzuführen, dass für jeden Alterungsprozess ein definierter Zwischenstand des Gesundheitszustands der Zelle erreicht wird, um auf diese Weise mit kontrollierter Alterung in den nächsten Alterungsprozess und/oder die weitere Alterungsschleife überzugehen.

Der finale Kerngedanke der vorliegenden Erfindung kommt im letzten Schritt zum Ausdruck. Hier werden nun Kalibrierinformationen ausgegeben, welche nicht mehr auf vollständige Lade- und Entladezyklen gemäß den bekannten Lösungen beschränkt sind, sondern vielmehr die Korrelation von insbesondere elektrischen Messwerten der Batteriezelle im Verlauf der Durchführung des Alterungsverfahrens und dem jeweils zugehörigen bestimmten Ist-SoH aufweisen. Mit anderen Worten beinhalten die Kalibrierinformationen damit eine Korrelation über den Verlauf der Alterung zwischen messbaren elektrischen Messparametern der angeschlossenen Batteriezelle und dem jeweils zuzuordnenden Gesundheitszustand der angeschlossenen Batteriezelle.

Die Kalibrierinformationen enthalten damit zumindest zwei wesentliche Bestandteile. Zum einen ist dies der durch die Referenzierungsschritte ermittelte Verlauf des Ist-SoH der angeschlossenen Batteriezelle. Zum anderen sind dies zu dem Verlauf des Ist-SoH gemessene Messwerte Teil der Kalibrierinformationen. Dabei kann es sich zum Beispiel um Temperaturwerte, Ladezyklen, Stromwerte, Spannungswerte, Widerstandswerte oder Ähnliches handeln. Die Kombination von an einem späteren Einsatzort in einem Fahrzeug ebenfalls wieder messbaren Messwerten mit dem Verlauf des Ist-SoH erlaubt eine Korrelation zwischen diesen beiden Parametergruppen. Eine mögliche Nutzung diese Kalibrierinformationen ist beispielsweise die Bestimmung eines Ist-SoH an einem Fahrzeug auf Basis der dann gemessenen Messwerte vom Prüfstand.

Beinhalten die Kalibrierinformationen zum Beispiel den Verlauf des Ist-SoH in Korrelation zu gemessenen Innenwiderständen der Batteriezelle, so kann bei einer Nutzung dieser Batteriezelle in einem Fahrzeug ein Batteriemanagementsystem (auch BMS genannt) nun in bekannter Weise den Innenwiderstand einer oder mehrerer Batteriezellen messen. Auf Basis dieser realen Messwerte kann mittels der Kalibrierinformation, im einfachsten Fall durch einen Vergleich mit den darin enthaltenen Zusammenhängen, auf den Ist-SoH zurück geschlossen werden. So steht bei diesem Beispiel der gemessene Innenwiderstand für einen damit zusammenhängenden Ist-SoH aus den Kalibrierinformationen.

Da die Alterung nun spezifisch für eine Nutzungsart erfolgt ist führt der Einsatz der Kalibrierinformationen aus unterschiedlichen Alterungsverfahren selbst bei einer identischen Batterievorrichtung zu unterschiedlichen Ergebnissen für einen Ist-SoH bei identischem Messwert zum Beispiel in Form des Innenwiderstands. Ohne aufwendiger Berechnung oder Simulation kann nun für eine Batterievorrichtung nutzungsspezifisch eine Kalibrierinformationen erzeugt werden, welche je nach Einsatzweck andere Zusammenhänge aufweist und zu anderen Auswertungen hinsichtlich der auszugebenden Werte für den Ist-SoH führt. Eine Batterievorrichtung wird demnach aufgrund der nutzungsspezifisch unterschiedlichen Kalibrierinformationen in einem Rennfahrzeug und bei einem Kleinwagen bei gleichem realem Messwert jeweils einen unterschiedlichen Ist-SoH ergeben. Bisher war diese Unterscheidung überhaupt nicht oder nur mit sehr aufwendigem Berechnungs- und Simulationsaufwand möglich.

Mit anderen Worten werden diese Kalibrierinformationen im einfachsten Fall in einem Batteriemanagementsystem der späteren Nutzung der Batteriezelle in einer Batterievorrichtung zugeführt. Somit wird es möglich, durch Überwachung und Bestimmung der gleichen Messwerte und die nun aus dem Alterungsverfahren und den Kalibrierinformationen bekannte Korrelation sehr genau zurückzuschließen auf den Gesundheitszustand der Batteriezellen in der Batterievorrichtung, welche von einem solchen BMS betrieben wird. Dies ist insbesondere sogar nutzungsspezifisch möglich, da mit großen Freiheitsgraden nicht nur eine Alterungsart, sondern zumindest zwei unterschiedliche Alterungsarten in einem erfindungsgemäßen Alterungsverfahren miteinander kombiniert worden sind. Auch ist es möglich, die Kalibrierinformationen nutzungsspezifisch auszuführen und sogar für unterschiedliche Nutzungsarten für ein und dieselbe Batterievorrichtung unterschiedliche Kalibrierinformationen zu verwenden. So können für eine Batterievorrichtung, welche später in einem Rennfahrzeug eingesetzt wird, entsprechend Kalibrierinformationen verwendet werden, welche mit für einen solchen Rennbetrieb typischen Alterungsmechanismen im Alterungsverfahren betrachtet worden ist. Wird die gleiche Batterievorrichtung in einem Kleinfahrzeug, beispielsweise für einen Kurzstreckenbetrieb eingesetzt, so kann trotz der Konstruktions- und Baugleichheit der Batteriezellen und der Batterievorrichtung ein komplett unterschiedlicher Satz an Kalibrierinformationen erzeugt und verwendet werden, da entsprechend das Alterungsverfahren sich mit dieser anderen nutzungsspezifischen Alterung beschäftigt und somit die Kalibrierinformationen auch diese andere Nutzungsart widerspiegeln.

Erfindungsgemäß wird es also nun möglich, mit dem Alterungsverfahren nicht nur nutzungsspezifisch auf unterschiedliche Einsatzzwecke einer Batterievorrichtung einzugehen, sondern auch die Durchführung des Alterungsverfahrens ist deutlich einfacher, da sie auf Zellenebene für einzelne Batteriezellen durchgeführt werden kann, und nicht mehr, wie in den bekannten Lösungen, für die komplette Batterievorrichtung.

Es kann Vorteile mit sich bringen, wenn bei einem erfindungsgemäßen Alterungsverfahren die erste Alterungsschleife und/oder die zweite Alterungsschleife wiederholt werden mit einem reduzierten ersten Alterungsgrenzwert und/oder einem reduzierten zweiten Alterungsgrenzwert. So ist es beispielsweise denkbar, die erste Alterungsschleife so lange durchzuführen, bis ein Verlust der Gesamtkapazität als Gesundheitszustand und damit State of Health von 3% erfolgt ist. Also beispielsweise eine Reduktion von 100% Ausgangs-SoH auf einen Ist-SoH nach der ersten Alterungsschleife von 97%. Die zweite Alterungsschleife kann in ähnlicher Weise bis zu einer Reduktion um weitere 3% also auf einen Ist-SoH von 94% durchgeführt werden. Für einen weiteren Durchlauf der ersten und zweiten Alterungsschleife können nun andere Grenzwerte vorgesehen werden. Diese könne beispielsweise geringer sein, da die Alterung üblicherweise nicht linear verläuft. So können beispielsweise die neuen Schrittweiten für den zweiten Gesamtdurchlauf auf 2% reduziert werden. Das bedeutet bei diesem Beispiel, dass beim zweiten Durchlauf der ersten Alterungsschleife diese so lange durchgeführt wird, bis sich der Ist-SoH von 94% auf 92% reduziert hat. In ähnlicher Weise kann die zweite Alterungsschleife im zweiten Gesamtdurchlauf bis zu einer Reduktion des Ist-SoH von 92% auf 90% durchgeführt werden. Selbstverständlich können auch komplexere Zusammenhänge für die Variation und Reduktion der Alterungsgrenzwerte in der übergeordneten Gesamtschleife Vorteile mit sich bringen.

Von Vorteil ist es ebenfalls, wenn bei einem erfindungsgemäßen Alterungsverfahren die Wiederholung der ersten Alterungsschleife und/oder der zweiten Alterungsschleife durchgeführt wird, bis ein absoluter Alterungsgrenzwert erreicht ist. Ähnlich den bekannten Lösungen gibt es gewisse Grenzen, welche auch als End-of-Life-Gesundheitszustand (EoL) bezeichnet werden. So werden Batterievorrichtungen und damit die einzelnen Batteriezellen in Fahrzeugen häufig nur so lange eingesetzt, bis sie eine Restkapazität von 80% erreichen. Ein solcher Ist-SoH als End-of-Life-Zustand kann auch als Abbruchkriterium für die Gesamtschleife eines erfindungsgemäßen Alterungsverfahrens eingesetzt werden. So ist es also denkbar, die Summe der einzelnen Alterungsschleifen in der definierten Reihenfolge so lange sequentiell zu wiederholen, bis der End-of-Life-Zustand in Form des absoluten Alterungsgrenzwerts erreicht und/oder unterschritten wird.

Ebenfalls Vorteile kann es mit sich bringen, wenn bei einem erfindungsgemäßen Alterungsverfahren für die erste Alterungsschleife und/oder für die zweite Alterungsschleife die Anzahl der Wiederholungen begrenzt ist. Beispielsweise kann hier ein weiteres Abbruchkriterium so vorgegeben werden, dass die Gesamtzahl der Wiederholungen einen Maximalwert nicht überschreitet. Führt ein Alterungsprozess nun zu sehr geringeren Alterungserscheinungen bei der angeschlossenen Batteriezelle, kann ein solches Abbruchkriterium in Form der Maximalzahl der Wiederholungen ein rechtzeitiges Übergeben an die zweite Alterungsschleife mit sich bringen. Andernfalls besteht die Gefahr, dass bei einer Alterungsschleife mit geringen Alterungserscheinungen sich das Alterungsverfahren zeitlich in die Länge zieht und somit ein Zeitnachteil die Folge ist. Mit anderen Worten ist es möglich, auch zwei oder sogar mehrere Abbruchkriterien in eine Alterungsschleife zu integrieren.

Von Vorteil ist es darüber hinaus, wenn bei einem erfindungsgemäßen Alterungsverfahren der erste Alterungsgrenzwert und/oder der zweite Alterungsgrenzwert sich durch einen vorgegebenen Reduktionsschritt von einem vorausgehenden Ist-SoH ergibt. Das kann zum Beispiel, wie bereits erläutert worden ist, ein definierter Kapazitätsverlust von zum Beispiel 3% sein. Dieser definierte Reduktionsschritt kann auch für die mehrfache Wiederholung der Alterungsschleifen sich verändern, also beispielsweise beim zweiten Gesamtdurchlauf aller Alterungsschleifen von 3%-Punkten auf 2%-Punkte reduziert werden. Dabei handelt es sich also um einen relativen Grenzwert, welcher auch als Schrittweite oder als Grenzschrittweite bezeichnet werden kann.

Weitere Vorteile sind darüber hinaus erzielbar, wenn bei einem erfindungsgemäßen Alterungsverfahren der vorgegebene Reduktionsschritt sich für unterschiedliche Alterungsprozesse und/oder für unterschiedliche Wiederholungen der Alterungsschleifen unterscheidet. Darunter ist zu verstehen, dass beispielsweise für unterschiedliche Gesamtdurchläufe und/oder für unterschiedliche Alterungsschleifen auch unterschiedliche Reduktionsschritte verwendet werden. Insbesondere dann, wenn aufgrund von physikalischen Überlegungen zu erwarten ist, dass ein nicht lineares Verhalten im Alterungsprozess der angeschlossenen Batteriezelle zu erwarten ist, kann eine Reduktion und eine Veränderung der Reduktionsschritte diesen physikalisch erwarteten Veränderungen in der Alterungsgeschwindigkeit Rechnung tragen. Ziel ist es hier insbesondere, die Gesamtzeit des Alterungsverfahrens zu reduzieren und gleichzeitig die Aussagekraft hinsichtlich der auszugebenden Kalibrierinformationen beizubehalten oder sogar zu erhöhen.

Weitere Vorteile kann es mit sich bringen, wenn bei einem erfindungsgemäßen Alterungsverfahren bei der Bestimmung des Ist-SoH wenigstens eine der folgenden Methoden eingesetzt wird:
- Messung der elektrischen Kapazität der angeschlossenen Batteriezelle,
- Messung des Innenwiderstands der angeschlossenen Batteriezelle,
- Einbringen von hybriden Leistungspulsen in die angeschlossenen Batteriezelle.

Bei der voranstehenden Aufzählung handelt es sich um eine nicht abschließende Liste. Selbstverständlich können auch mehrere Messmethoden miteinander kombiniert werden. Insbesondere wird beispielsweise die elektrische Kapazität bestimmt, um aus dieser den aktuellen Gesundheitszustand zu ermitteln oder direkt die Restkapazität im Vergleich zur Nominalkapazität als Gesundheitszustand und damit als Ist-SoH zu setzen. Die weiteren Messungen, beispielsweise die Messung des Innenwiderstandes, kann zum Beispiel dahingehend verwendet werden, um die Messwerte in Korrelation des bestimmten Ist-SoH zu bewerten und später als Teil der Kalibrierinformationen auszugeben.

Auch Vorteile kann es mit sich bringen, wenn bei einem erfindungsgemäßen Alterungsverfahren in der ersten Alterungsschleife der erste Alterungsprozess und/oder in der zweiten Alterungsschleife der zweite Alterungsprozess mehrfach wiederholt wird, bevor die Referenzierung durchgeführt wird. Insbesondere dann, wenn durch physikalische Überlegungen davon auszugehen ist, dass der Ist-SoH pro durchgeführtem Alterungsprozess nur minimal absinkt, kann auf einzelne Zwischenreferenzierungen verzichtet werden, sodass die Gesamtzeit für den Durchlauf der jeweiligen Alterungsschleife reduziert wird. Beispielsweise ist hier sogar eine Prognose möglich, um welchen Reduktionsschritt pro durchgeführtem Alterungsprozess der zu referenzierende Ist-SoH in erwarteter Weise absinken wird. Auf Basis dieser Prognose, welche beispielsweise modellbasiert vorgegeben werden kann, ist es nun möglich, die tatsächliche Referenzierung nicht mehr nach jedem Alterungsprozess durchzuführen, sondern nach definierten und gezielten Mehrfachdurchläufen, und somit die Anzahl der Zwischenreferenzierungen pro Alterungsschleife zu reduzieren und die Gesamtzeit des Alterungsverfahrens zu minimieren.

Auch Vorteile kann es mit sich bringen, wenn bei einem erfindungsgemäßen Alterungsverfahren der erste Alterungsprozess und/oder der zweite Alterungsprozess wenigstens eine der folgenden Alterungs-Prozessschritte aufweist:
- Entladen der angeschlossenen Batteriezelle auf einem definierten Entladezustand,
- Laden der angeschlossenen Batteriezelle auf einen definierten Ladezustand,
- Temperieren der angeschlossenen Batteriezelle auf eine definierte Temperatur,
- Einstellen eines definierten Entladestroms für die angeschlossene Batteriezelle,
- Einstellen eines definierten Ladestroms für die angeschlossene Batteriezelle,
- Einbringen von mechanischer Belastung in die angeschlossene Batteriezelle,
- Begrenzung auf Betriebsgrenzen im realen Betrieb der angeschlossenen Batteriezelle.

Auch bei der voranstehenden Aufzählung handelt es sich um eine nicht abschließende Liste. Selbstverständlich können auch zwei oder mehr dieser Schritte gemeinsam vorgesehen sein oder sogar miteinander überlappen. Auch ist es möglich, die einzelnen Alterungsprozesse unterschiedlich durchzuführen und insbesondere in unterschiedlichen Wiederholungen der Alterungsschleife zu variieren. So kann beispielsweise auf eine Temperatur eingestellt werden und eine definierte Zahl von vollen Lade- und Entladezyklen durchgeführt werden. In einer weiteren Wiederholung im Alterungsprozess wird bei gleicher Temperatur nun ein Kurzstreckenbetrieb simuliert, mit einem Pendeln zwischen zwei definierten Ladezuständen, beispielsweise zwischen 80% und 50% Ladezustand (State of Charge - SoC) der angeschlossenen Batteriezelle. In einer alternativen Lösung können mit sehr hohen Ladeströmen und Entladeströmen Schnellladezyklen und ein hoher Verbrauch, beispielsweise beim Betrieb auf einer Rennstrecke, simuliert werden. Hier ist gut zu erkennen, dass durch die entsprechende Auswahl und Parametrisierung der einzelnen Alterungs-Prozessschritte eine definierte Anpassung an unterschiedliche nutzungsspezifische Anforderungen und/oder unterschiedliche Alterungssituationen möglich ist.

Weitere Vorteile sind ebenfalls erzielbar, wenn bei einem erfindungsgemäßen Alterungsverfahren der erste Alterungsprozess und/oder der zweite Alterungsprozess, insbesondere durch gezielte Auswahl und Reihenfolge von

Alterungs-Prozessschritten, für wenigstens eine der folgenden Alterungsarten spezifisch ist:
- reiner Batteriebetrieb eines Fahrzeugs,
- Plug-In-Hybrid-Betrieb eines Fahrzeugs,
- kalendarische Alterung,
- Schnellladebetrieb,
- Langsam ladebetrieb.

Auch bei der voranstehenden Aufzählung handelt es sich um eine nicht abschließende Liste, welche insbesondere auch Kombinationen der einzelnen Schritte ermöglicht. So ist es möglich, an unterschiedliche Batteriebetrieben und/oder Betriebsarten des Fahrzeugs, wie auch unterschiedliche Alterungssysteme und - prozesse, die einzelnen Alterungsprozesse anzupassen und entsprechend die Schleifen dahingehend zu variieren. Somit wird es möglich, in nutzungsspezifischer Weise die Alterung zu beschleunigen und trotzdem eine sehr hohe Aussagekraft durch Realitätsnähe zur Verfügung zu stellen. Mit anderen Worten werden die auf diese Weise erzeugten und ausgegeben Kalibrierinformationen sehr realitätsnah die Alterung im späteren Einsatz in einem Fahrzeug wiedergeben und somit sehr genau einen Rückschluss auf den tatsächlichen Ist-SoH bei dem entsprechend kalibrierten Batteriemanagementsystem (BMS) erlauben.

Weitere Vorteile kann es darüber hinaus mit sich bringen, wenn bei einem erfindungsgemäßen Alterungsverfahren der erste Alterungsprozess und/oder der zweite Alterungsprozess, insbesondere durch gezielte Auswahl und Reihenfolge von Alterungs-Prozessschritten, an ein vorgegebenes Nutzungsprofil der angeschlossenen Batteriezelle in einem Fahrzeug angepasst sind, insbesondere wenigstens eines der folgenden:
- Betrieb auf einer Rennstrecke,
- Pendlerbetrieb,
- Kurzstreckenbetrieb,
- Langstreckenbetrieb,
- Betrieb mit einer Photovoltaikanlage.

Auch die voranstehende Aufzählung ist eine nicht abschließende Liste. Auch hier sind wieder Kombinationen der einzelnen Nutzungsarten denkbar. Auch ist darauf hinzuweisen, dass selbstverständlich unterschiedliche Betriebsarten miteinander kombiniert sein können, also beispielsweise der Kurzstreckenbetrieb mit dem Pendelbetrieb oder Ähnliches.

Weiters von Vorteil ist es ebenfalls, wenn bei einem erfindungsgemäßen Alterungsverfahren es für wenigstens zwei angeschlossene Batteriezellen zeitlich zumindest teilweise parallel durchgeführt wird, mit identischen oder im Wesentlichen identischen Alterungsschleifen. Mit anderen Worten wird hier eine redundante Alterung durchgeführt, sodass die beiden angeschlossenen Batteriezellen im Wesentlichen identisch betrieben und identisch gealtert werden. Die Ausgabe der Kalibrierinformationen kann separat voneinander erfolgen und beispielsweise anschließend für das Erzeugen von Mittelwerten verwendet werden. Die redundanten, durch die realen Messungen aber wahrscheinlich voneinander leicht abweichenden Detailinformationen, bilden damit Mittelwerte, welche eine noch höhere Genauigkeit und Realitätsnähe der Kalibierinformationen zur Verfügung stellen können.

Vorteile bringt es weiter mit sich, wenn bei einem erfindungsgemäßen Alterungsverfahren dieses für wenigstens zwei angeschlossenen Batteriezellen zeitlich zumindest teilweise parallel durchgeführt wird mit unterschiedlichen Alterungsschleifen. Im Unterschied zum voranstehenden Absatz ist dies dahingehend zu verstehen, dass nun abhängig von unterschiedlichen Nutzungsarten oder unterschiedlichen Alterungsprozesse auch zeitlich parallel unterschiedliche Kalibrierinformationen zur Verfügung gestellt und ausgegeben werden können. So kann später ein Batteriemanagementsystem beispielsweise zwischen unterschiedlichen Kalibrierinformationen umschalten, je nachdem welche Nutzungssituation und damit welche zu erwartende Alterungssituation aktuell vorliegt. Dies ermöglicht es auch bei komplexen Nutzungssituationen ein Batteriemanagementsystem mit einer entsprechend flexiblen Managementkalibrierung auszustatten, um auf diese Weise ein noch genaueres Nachhalten und Nachführen des Gesundheitszustandes der einzelnen Batteriezellen in der Batterievorrichtung eines solchen Fahrzeugs zu erlauben.

Weiterer Gegenstand der vorliegenden Erfindung ist eine Alterungsvorrichtung für eine Durchführung eines Alterungsverfahrens auf einem Prüfstand für eine nutzungsspezifische beschleunigte Alterung von Batteriezellen zur Erzeugung von Kalibrierinformationen. Hierfür weist die Alterungsvorrichtung ein Aufnahmemodul für eine Aufnahme und einen elektrischen Anschluss wenigstens einer Batteriezelle auf. Eine solche Alterungsvorrichtung zeichnet sich dadurch aus, dass ein Referenzierungsmodul für ein Durchführen einer Referenzierung zur Bestimmung eines Ist-SoH einer angeschlossenen Batteriezelle vorgesehen ist. Weiter ist ein Schleifenmodul vorgesehen für ein Durchführen der ersten Alterungsschleife und ein zweites Schleifenmodul für ein Durchführen der zweiten Alterungsschleife. Mit Hilfe eines Ausgabemoduls erfolgt ein Ausgeben der Kalibrierinformationen, welche zu wenigstens einem der bestimmten Ist-SoH zugehörigen Messwerte der angeschlossenen Batteriezelle beinhalten. Das Referenzierungsmodul, das erste Schleifenmodul, das zweite Schleifenmodul und/oder das Ausgabemodul sind insbesondere für die Durchführung eines erfindungsgemäßen Alterungsverfahrens ausgebildet. Damit bringt auch eine solche Alterungsvorrichtung die gleichen Vorteile mit sich, wie sie ausführlich mit Bezug auf ein erfindungsgemäßes Alterungsverfahren erläutert worden sind.

Ebenfalls Gegenstand der vorliegenden Erfindung ist ein Computerprogrammprodukt, aufweisend Befehle, welche bei der Ausführung auf einem Computer diesen veranlassen ein erfindungsgemäßes Alterungsverfahren auszuführen. Auch ein solches Computerprogrammprodukt bringt damit die gleichen Vorteile mit sich, wie sie ausführlich mit Bezug auf ein erfindungsgemäßes Alterungsverfahren erläutert worden sind.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen schematisch:
- Fig. 1: eine Ausführungsform einer erfindungsgemäßen Alterungsvorrichtung,
- Fig. 2: ein erster Schritt eines erfindungsgemäßen Alterungsverfahrens,
- Fig. 3: ein weiterer Schritt eines erfindungsgemäßen Alterungsverfahrens,
- Fig. 4: ein weiterer Schritt eines erfindungsgemäßen Alterungsverfahrens,
- Fig. 5: eine Detaildarstellung eines Alterungsprozesses,
- Fig. 6: eine schematische Darstellung unterschiedlicher Alterungsschleifen und
- Fig. 7: eine weitere Darstellung unterschiedlicher Alterungsschleifen.

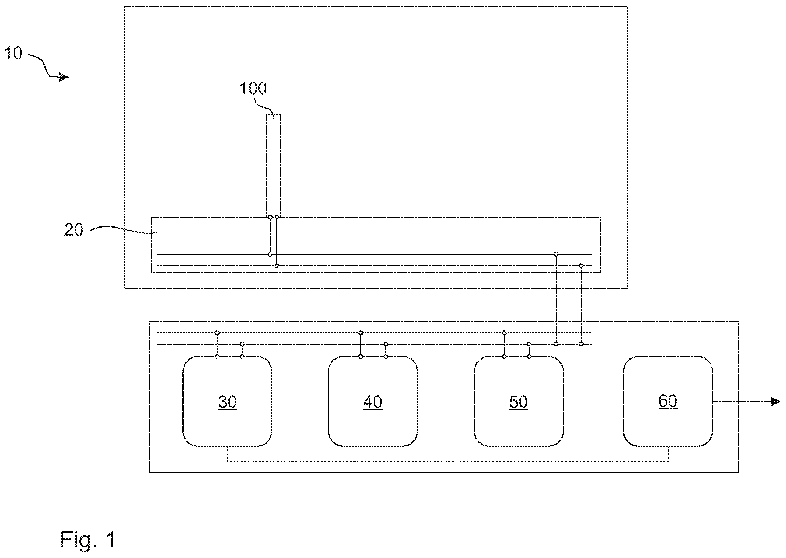

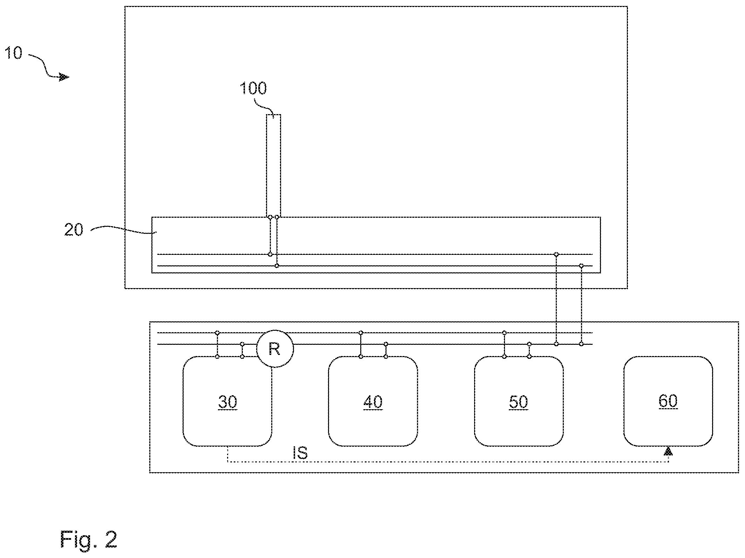

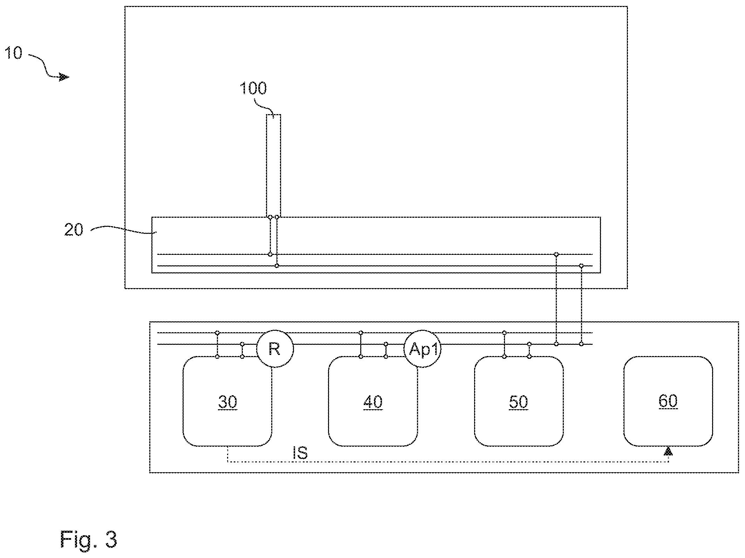

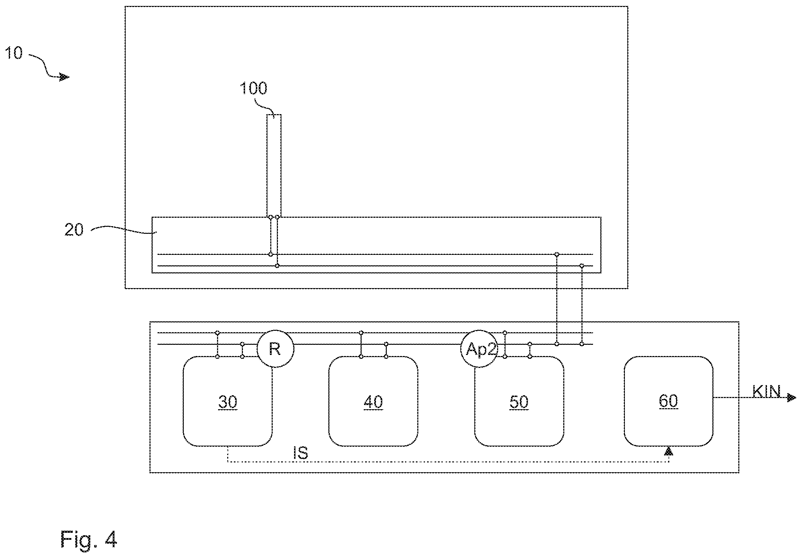

So zeigt die Figur 1 eine Ausführungsform einer erfindungsgemäßen Alterungsvorrichtung 10. In einer Klimakammer zur Temperierung ist hier ein Aufnahmemodul 20 angeordnet, in welchem hier schematisch eine Batteriezelle 100 elektrisch leitend angeordnet und damit elektrisch angeschlossen ist. Auf einem entsprechenden elektrischen Bussystem können selbstverständlich auch mehrere Batteriezellen 100 angeschlossen und damit zeitlich parallel mit den gleichen Lade- und Entladezyklen beaufschlagt werden. In einem darunter angeordneten Kontrollmodul ist ein Referenzierungsmodul 30, ein erstes Schleifenmodul 40 und ein zweites Schleifenmodul 50 vorgesehen, welche entsprechende elektrische Signale und Lade- und Entladezyklen mit der Alterungsvorrichtung 10 austauschen können. Im Ausgabemodul 60 können die erzeugten Kalibrierinformationen KIN später ausgegeben werden. Anhand der Figuren 2, 3 und 4 wird grob der Ablauf eines erfindungsgemäßen Alterungsverfahrens näher erläutert.

So zeigt die Figur 2 den Start des Alterungsverfahrens, indem das Referenzierungsmodul 30 eine Referenzierung R durchführt. Hier wird insbesondere der Nominalwert der angeschlossenen Batteriezelle 100 festgesetzt, also der Gesundheitszustand auf 100% als Ausgangszustand und Ausgangswert gesetzt. Sobald dies erfolgt, startet das Alterungsverfahren mit der Durchführung der ersten Alterungsschleife AS1, welche hier den ersten Alterungsprozess AP1 durch das erste Schleifmodul 40 appliziert. Nach einer oder mehreren durchgeführten Alterungsprozessen AP1 erfolgt eine Zwischenreferenzierung als Referenzierung R, um zu erkennen, ob das Abbruchkriterium für die erste Alterungsschleife AS1 bereits erreicht ist. Im Anschluss an die erste Alterungsschleife AS1 erfolgt die zweite Alterungsschleife AS2 durch das zweite Schleifmodul 50. Hier wird in wechselnder Sequenz ein zweiter Alterungsprozess AP2 und eine Referenzierung R durchgeführt, um ebenfalls das Abbruchkriterium des zweiten Alterungsgrenzwerts AG2 zu überwachen. Im Abschluss an alle Alterungsschleifen AS1 und AS2 erfolgt eine Übergabe der jeweiligen Ist-SoH-Werte und weiterer Informationen und die Ausgabe als Kalibrierinformationen KIN aus dem Ausgabemodul 60.

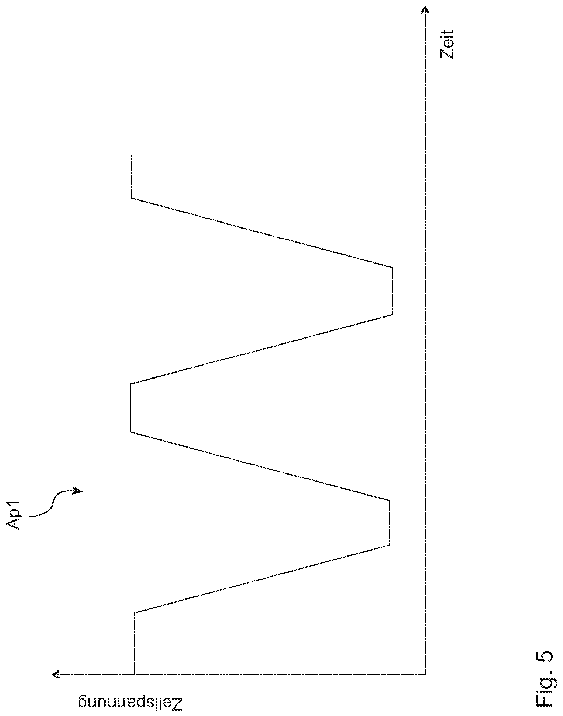

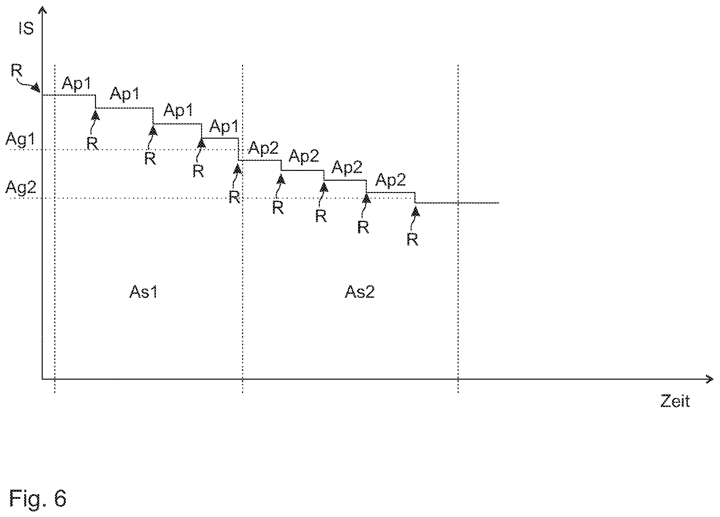

Die Figur 5 zeigt schematisch wie ein Alterungsprozess AP in sehr einfacher Weise aufgebaut sein kann. So kann hier die Zellspannung als Ladezustand über die Zeit variiert werden zwischen hier zwei definierten Ladezyklen. Entscheidend ist, wie sich diese Ladezyklen oder andere Parameter des Alterungsprozesses AP1 und des Alterungsprozesses AP2 auf den Gesundheitszustand und damit auf den Ist-SoH IS auswirken. Dies ist in Figur 6 näher dargestellt. So wird hier nach der Ist-SoH IS an der Y-Achse dargestellt und über die Zeit verändert, indem ein beschleunigtes Altern durch die Alterungsprozesse AP1 und AP2 appliziert wird. In der ersten Alterungsschleife AS1 erfolgt ein viermaliges Durchführen und viermaliges Referenzieren R der ersten Alterungsprozesse AP1 bis der erste Alterungsgrenzwert AG1 unterschritten wird. Dann schaltet das Alterungsverfahren auf die zweite Alterungsschleife AS2 um, in welcher wiederum viermal der zweite Alterungsprozess AP2 durchgeführt wird und durch die jeweils anschließende Zwischenreferenzierung R das Abbruchkriterium beim Unterschreiten des zweiten Alterungsgrenzwerts AG2 erkannt wird.

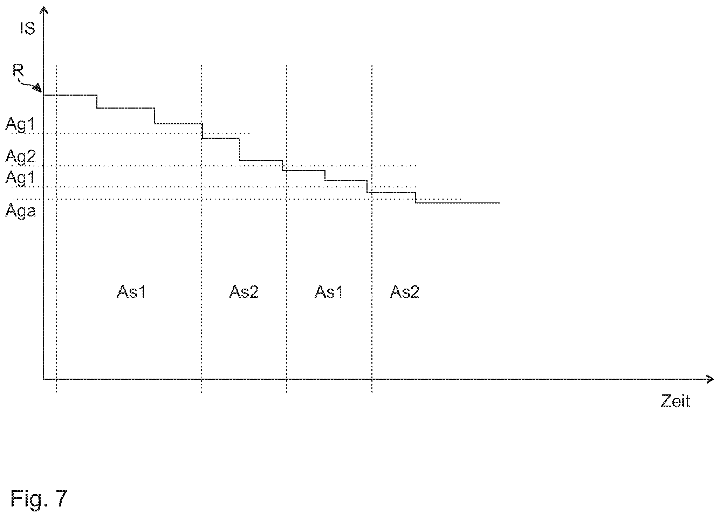

Die Figur 7 zeigt eine Variante, bei welcher die Schleifendurchführung der ersten und zweiten Alterungsschleife AS1 und AS2 zweimalig erfolgt, und zwar so lange bis beim zweiten Durchlauf der zweiten Alterungsschleife AS2 auch der absolute Alterungsgrenzwert AGA unterschritten wird.

Die voranstehende Erläuterung der Ausführungsform beschreibt die vorliegende Erfindung ausschließlich im Rahmen von Beispielen.

### Bezugszeichenliste

- 10: Alterungsvorrichtung
- 20: Aufnahmemodul
- 30: Referenzierungsmodul
- 40: erstes Schleifenmodul
- 50: zweites Schleifenmodul
- 60: Ausgabemodul

- 100: Batteriezelle

- KIN: Kalibrierinformationen
- R: Referenzierung
- IS: Ist-SoH
- AS1: erste Alterungsschleife
- AP1: erster Alterungsprozess
- AG1: erster Alterungsgrenzwert
- AS2: zweite Alterungsschleife
- AP2: zweiter Alterungsprozess
- AG2: zweiter Alterungsgrenzwert
- AGA: absoluter Alterungsgrenzwert

## Patentansprüche

1. Alterungsverfahren für eine nutzungsspezifische beschleunigte Alterung von Batteriezellen (100) auf einem Prüfstand zur Erzeugung von Kalibrierinformationen (KIN), wobei das Alterungsverfahren die folgenden Schritte aufweist:
- Elektrisches Anschließen wenigstens einer Batteriezelle (100) an einer Alterungsvorrichtung (10),
- Durchführen einer Referenzierung (R) zur Bestimmung eines Ist-SoH (IS) an der angeschlossenen Batteriezelle (100),
- Durchführen einer ersten Alterungsschleife (AS1), aufweisend
∘ einen ersten Alterungsprozess (AP1), welcher für eine erste Alterungsart der angeschlossenen Batteriezelle (100) spezifisch ist, mit anschließender Referenzierung (R) zur Bestimmung des Ist-SoH (IS) der angeschlossenen Batteriezelle (100) nach dem ersten Alterungsprozess (AP1),
∘ Vergleich des bestimmten Ist-SoH (IS) mit einem ersten Alterungsgrenzwert (AG1) und Wiederholen des ersten Alterungsprozesses (AP1) und der Referenzierung (R) bis der bestimmte Ist-SoH (IS) den ersten Alterungsgrenzwert (AG1) unterschreitet,
- Durchführen einer zweiten Alterungsschleife (AS2), aufweisend
∘ einen zweiten Alterungsprozess (AP2), welcher für eine zweite Alterungsart der angeschlossenen Batteriezelle (100) spezifisch ist, welche sich von der ersten Alterungsart unterscheidet, mit anschließender Referenzierung (R) zur Bestimmung des Ist-SoH (IS) der angeschlossenen Batteriezelle (100) nach dem zweiten Alterungsprozess (AP2),
∘ Vergleich des bestimmten Ist-SoH (IS) mit einem zweiten Alterungsgrenzwert (AG2) und Wiederholen des zweiten Alterungsprozesses (AP2) und der Referenzierung (R) bis der bestimmte Ist-SoH (IS) den zweiten Alterungsgrenzwert (AG2) unterschreitet,
- Ausgeben von Kalibrierinformationen (KIN), welche zu wenigstens einem der bestimmten Ist-SoH (IS) zugehörige Messwerte der angeschlossenen Batteriezelle (100) beinhalten zur Nutzung in einer Kontrollvorrichtung eines Fahrzeugs.

2. Alterungsverfahren nach Anspruch 1, **dadurch gekennzeichnet, dass** die erste Alterungsschleife (AS1) und/oder die zweite Alterungsschleife (AS2) wiederholt werden mit einem reduzierten ersten Alterungsgrenzwert (AG1) und/oder einem reduzierten zweiten Alterungsgrenzwert (AG2).

3. Alterungsverfahren nach Anspruch 2, **dadurch gekennzeichnet, dass** die Wiederholung der ersten Alterungsschleife (AS1) und/oder der zweiten Alterungsschleife (AS2) durchgeführt wird, bis ein absoluter Alterungsgrenzwert (AGA) erreicht ist.

4. Alterungsverfahren nach einem der vorangegangenen Ansprüche, **dadurch gekennzeichnet, dass** für die erste Alterungsschleife (AS1) und/oder die zweite Alterungsschleife (AS2) die Anzahl der Wiederholungen begrenzt ist.

5. Alterungsverfahren nach einem der vorangegangenen Ansprüche, **dadurch gekennzeichnet, dass** der erste Alterungsgrenzwert (AG1) und/oder der zweite Alterungsgrenzwert (AG2) sich durch einen vorgegebenen Reduktionsschritt von einem vorausgehenden Ist-SoH (IS) ergibt.

6. Alterungsverfahren nach Anspruch 5, **dadurch gekennzeichnet, dass** der vorgegebene Reduktionsschritt sich für unterschiedliche Alterungsprozesse (AP1, AP2) und/oder für unterschiedliche Wiederholungen der Alterungsschleifen (AS1, AS2) unterscheidet.

7. Alterungsverfahren nach einem der vorangegangenen Ansprüche, **dadurch gekennzeichnet, dass** bei der Bestimmung des Ist-SoH (IS) wenigstens eine der folgenden Methoden eingesetzt wird:
- Messung der elektrischen Kapazität der angeschlossenen Batteriezelle (100)
- Messung des Innenwiderstandes der angeschlossenen Batteriezelle (100)
- Einbringen von hybriden Leistungspulsen in die angeschlossenen Batteriezelle (100)

8. Alterungsverfahren nach einem der vorangegangenen Ansprüche, **dadurch gekennzeichnet, dass** in der ersten Alterungsschleife (AS1) der erste Alterungsprozess (AP1) und/oder in der zweiten Alterungsschleife (AS2) der zweite Alterungsprozess (AP2) mehrfach wiederholt wird, bevor die Referenzierung (R) durchgeführt wird.

9. Alterungsverfahren nach einem der vorangegangenen Ansprüche, **dadurch gekennzeichnet, dass** der erste Alterungsprozess (AP1) und/oder der zweite Alterungsprozess (AP2) wenigstens einen der folgenden Alterungs-Prozessschritte aufweisen:
- Entladen der angeschlossenen Batteriezelle (100) auf einen definierten Entladezustand
- Laden der angeschlossenen Batteriezelle (100) auf einen definierten Ladezustand
- Temperieren der angeschlossenen Batteriezelle (100) auf eine definierte Temperatur
- Einstellen eines definierten Entladestroms für die angeschlossene Batteriezelle (100)
- Einstellen eines definierten Ladestroms für die angeschlossene Batteriezelle (100)
- Einbringen von mechanischer Belastung in die angeschlossene Batteriezelle (100)
- Begrenzung auf Betriebsgrenzen im realen Betrieb der angeschlossenen Batteriezelle (100)

10. Alterungsverfahren nach einem der vorangegangenen Ansprüche, **dadurch gekennzeichnet, dass** der erste Alterungsprozess (AP1) und/oder der zweite Alterungsprozess (AP2), insbesondere durch gezielte Auswahl und Reihenfolge von Alterungs-Prozessschritten, für wenigstens eine der folgenden Alterungsarten spezifisch ist:
- Reiner Batteriebetrieb eines Fahrzeugs
- Plugin-Hybrid-Betrieb eines Fahrzeugs
- Kalendarische Alterung
- Schnellladebetrieb
- Langsamladebetrieb

11. Alterungsverfahren nach einem der vorangegangenen Ansprüche, **dadurch gekennzeichnet, dass** der erste Alterungsprozess (AP1) und/oder der zweite Alterungsprozess (AP2), insbesondere durch gezielte Auswahl und Reihenfolge von Alterungs-Prozessschritten, an ein vorgegebenes Nutzungsprofil der angeschlossenen Batteriezelle (100) in einem Fahrzeug angepasst sind, insbesondere wenigstens eines der folgenden:
- Betrieb auf einer Rennstrecke
- Pendlerbetrieb
- Kurzstreckenbetrieb
- Langstreckenbetrieb
- Betrieb mit einer Photovoltaikanlage

12. Alterungsverfahren nach einem der vorangegangenen Ansprüche, **dadurch gekennzeichnet, dass** es für wenigstens zwei angeschlossene Batteriezellen (100) zeitlich zumindest teilweise parallel durchgeführt wird mit identischen oder im Wesentlichen identischen Alterungsschleifen (AS1, AS2).

13. Alterungsverfahren nach einem der vorangegangenen Ansprüche, **dadurch gekennzeichnet, dass** es für wenigstens zwei angeschlossene Batteriezellen (100) zeitlich zumindest teilweise parallel durchgeführt wird mit unterschiedlichen Alterungsschleifen (AS1, AS2).

14. Alterungsvorrichtung (10) für eine Durchführung eines Alterungsverfahrens für eine nutzungsspezifische beschleunigte Alterung von Batteriezellen (100) auf einem Prüfstand zur Erzeugung von Kalibrierinformationen (KIN), aufweisend ein Aufnahmemodul (20) für eine Aufnahme und einen elektrischen Anschluss wenigstens einer Batteriezelle (100), wobei die Alterungsvorrichtung aufweist: ein Referenzierungsmodul (30) für ein Durchführen einer Referenzierung (R) zur Bestimmung eines Ist-SoH (IS) einer angeschlossenen Batteriezelle (100), ein erstes Schleifenmodul (40) für ein Durchführen der ersten Alterungsschleife (AS1), ein zweites Schleifenmodul (50) für ein Durchführen einer zweiten Alterungsschleife (AS2) und ein Ausgabemodul (60) für ein Ausgeben von Kalibrierinformationen (KIN), welche zu wenigstens einem der bestimmten Ist-SoH (IS) zugehörige Messwerte der angeschlossenen Batteriezelle (100) beinhalten, wobei das Referenzierungsmodul (30), das erste Schleifenmodul (40), das zweite Schleifenmodul (50) und/oder das Ausgabemodul (60) für eine Durchführung eines Alterungsverfahrens mit den Merkmalen eines der Ansprüche 1 bis 13 ausgebildet sind.

15. Computerprogrammprodukt, aufweisend Befehle, welche bei der Ausführung auf einem Computer diesen veranlassen die Schritte eines Alterungsverfahrens mit den Merkmalen eines der Ansprüche 1 bis 13 auszuführen.

## Claims

1. Aging method for a usage-specific accelerated aging of battery cells (100) on a test bench for generating calibration information (KIN), wherein the aging method comprises the following steps:
- Electrically connecting at least one battery cell (100) to an aging device (10),
- Carrying out a referencing (R) for determining an actual SoH (IS) on the connected battery cell (100),
- Carrying out a first aging loop (AS1), comprising
∘ a first aging process (AP1), which is specific for a first aging type of the connected battery cell (100), with subsequent referencing (R) for determining the actual SoH (IS) of the connected battery cell (100) after the first aging process (AP1),
∘ comparison of the determined actual SoH (IS) with a first aging limit value (AG1) and repeating the first aging process (AP1) and the referencing (R) until the determined actual SoH (IS) falls below the first aging limit value (AG1),
- Carrying out a second aging loop (AS2), comprising
∘ a second aging process (AP2), which is specific for a second aging type of the connected battery cell (100), which differs from the first aging type, with subsequent referencing (R) for determining the actual SoH (IS) of the connected battery cell (100) after the second aging process (AP2),
∘ comparison of the determined actual SoH (IS) with a second aging limit value (AG2) and repeating the second aging process (AP2) and the referencing (R) until the determined actual SoH (IS) falls below the second aging limit value (AG2),
- Outputting calibration information (KIN), which comprise measured values of the connected battery cell (100) associated with at least one of the determined actual SoH (IS), for use in a control device of a vehicle.

2. Aging method according to claim 1, **characterized in that** the first aging loop (AS1) and/or the second aging loop (AS2) are repeated with a reduced first aging limit value (AG1) and/or a reduced second aging limit value (AG2).

3. Aging method according to claim 2, **characterized in that** the repetition of the first aging loop (AS1) and/or of the second aging loop (AS2) is carried out until an absolute aging limit value (AGA) is reached.

4. Aging method according to one of the preceding claims, **characterized in that** the number of repetitions is limited for the first aging loop (AS1) and/or the second aging loop (AS2).

5. Aging method according to one of the preceding claims, **characterized in that** the first aging limit value (AG1) and/or the second aging limit value (AG2) results from a preceding actual SoH (IS) by a predetermined reduction step.

6. Aging method according to claim 5, **characterized in that** the predetermined reduction step differs for different aging processes (AP1, AP2) and/or for different repetitions of the aging loops (AS1, AS2).

7. Aging method according to one of the preceding claims, **characterized in that**, in determining the actual SoH (IS), at least one of the following methods is employed:
- Measuring the electrical capacity of the connected battery cell (100)
- Measuring the internal resistance of the connected battery cell (100)
- Applying hybrid power pulses to the connected battery cell (100).

8. Aging method according to one of the preceding claims, **characterized in that**, in the first aging loop (AS1), the first aging process (AP1) and/or, in the second aging loop (AS2), the second aging process (AP2) is repeated multiple times before the referencing (R) is carried out.

9. Aging method according to one of the preceding claims, **characterized in that** the first aging process (AP1) and/or the second aging process (AP2) comprise at least one of the following aging process steps:
- Discharging the connected battery cell (100) to a defined discharge state
- Charging the connected battery cell (100) to a defined charge state
- Tempering the connected battery cell (100) to a defined temperature
- Setting a defined discharge current for the connected battery cell (100)
- Setting a defined charge current for the connected battery cell (100)
- Introducing mechanical loading into the connected battery cell (100)
- Limitation to operating limits in the real operation of the connected battery cell (100)

10. Aging method according to one of the preceding claims, **characterized in that** the first aging process (AP1) and/or the second aging process (AP2), in particular by targeted selection and sequence of aging process steps, is specific for at least one of the following aging types:
- Pure battery operation of a vehicle
- Plug-in hybrid operation of a vehicle
- Calendar aging
- Fast charging operation
- Slow charging operation

11. Aging method according to one of the preceding claims, **characterized in that** the first aging process (AP1) and/or the second aging process (AP2), in particular by targeted selection and sequence of aging process steps, are adapted to a predetermined usage profile of the connected battery cell (100) in a vehicle, in particular at least one of the following:
- Operation on a race track
- Commuter operation
- Short-distance operation
- Long-distance operation
- Operation with a photovoltaic installation

12. Aging method according to one of the preceding claims, **characterized in that** it is carried out for at least two connected battery cells (100) at least partially in parallel in time with identical or substantially identical aging loops (AS1, AS2).

13. Aging method according to one of the preceding claims, **characterized in that** it is carried out for at least two connected battery cells (100) at least partially in parallel in time with different aging loops (AS1, AS2).

14. Aging device (10) for carrying out an aging method for a usage-specific accelerated aging of battery cells (100) on a test bench for generating calibration information (KIN), comprising a receiving module (20) for receiving and electrically connecting at least one battery cell (100), wherein the aging device comprises:
a referencing module (30) for carrying out a referencing (R) for determining an actual SoH (IS) of a connected battery cell (100), a first loop module (40) for carrying out the first aging loop (AS1), a second loop module (50) for carrying out a second aging loop (AS2), and an output module (60) for outputting calibration information (KIN), which comprise measured values of the connected battery cell (100) associated with at least one of the determined actual SoH (IS), wherein the referencing module (30), the first loop module (40), the second loop module (50) and/or the output module (60) are designed for carrying out an aging method having the features of one of claims 1 to 13.

15. Computer program product, comprising instructions which, when executed on a computer, cause the computer to carry out the steps of an aging method having the features of one of claims 1 to 13.

## Revendications

1. Procédé de vieillissement pour un vieillissement accéléré spécifique à l'utilisation de cellules de batterie (100) sur un banc d'essai destiné à générer des informations d'étalonnage (KIN), le procédé de vieillissement comprenant les étapes suivantes :
- raccordement électrique d'au moins une cellule de batterie (100) à un dispositif de vieillissement (10),
- réalisation d'un référencement (R) pour la détermination d'un SoH actuel (IS) sur la cellule de batterie (100) raccordée,
- réalisation d'une première boucle de vieillissement (AS1), comprenant
• un premier processus de vieillissement (AP1), qui est spécifique à un premier type de vieillissement de la cellule de batterie (100) raccordée, avec référencement (R) subséquent pour la détermination du SoH actuel (IS) de la cellule de batterie (100) raccordée après le premier processus de vieillissement (AP1),
• comparaison du SoH actuel (IS) déterminé avec une première valeur limite de vieillissement (AG1) et répétition du premier processus de vieillissement (AP1) et du référencement (R) jusqu'à ce que le SoH actuel (IS) déterminé passe en dessous de la première valeur limite de vieillissement (AG1),
- - réalisation d'une deuxième boucle de vieillissement (AS2), comprenant
• un deuxième processus de vieillissement (AP2), qui est spécifique à un deuxième type de vieillissement de la cellule de batterie (100) raccordée, lequel diffère du premier type de vieillissement, avec référencement (R) subséquent pour la détermination du SoH actuel (IS) de la cellule de batterie (100) raccordée après le deuxième processus de vieillissement (AP2),
• comparaison du SoH actuel (IS) déterminé avec une deuxième valeur limite de vieillissement (AG2) et répétition du deuxième processus de vieillissement (AP2) et du référencement (R) jusqu'à ce que le SoH actuel (IS) déterminé passe en dessous de la deuxième valeur limite de vieillissement (AG2),
- émission d'informations d'étalonnage (KIN), qui comprennent des valeurs mesurées de la cellule de batterie (100) raccordée associées à au moins un des SoH actuels (IS) déterminés, destinées à être utilisées dans un dispositif de commande d'un véhicule.

2. Procédé de vieillissement selon la revendication 1, **caractérisé en ce que** la première boucle de vieillissement (AS1) et/ou la deuxième boucle de vieillissement (AS2) sont répétées avec une première valeur limite de vieillissement réduite (AG1) et/ou une deuxième valeur limite de vieillissement réduite (AG2).

3. Procédé de vieillissement selon la revendication 2, **caractérisé en ce que** la répétition de la première boucle de vieillissement (AS1) et/ou de la deuxième boucle de vieillissement (AS2) est réalisée jusqu'à ce qu'une valeur limite de vieillissement absolue (AGA) soit atteinte.

4. Procédé de vieillissement selon l'une quelconque des revendications précédentes, **caractérisé en ce que**, pour la première boucle de vieillissement (AS1) et/ou la deuxième boucle de vieillissement (AS2), le nombre de répétitions est limité.

5. Procédé de vieillissement selon l'une quelconque des revendications précédentes, **caractérisé en ce que** la première valeur limite de vieillissement (AG1) et/ou la deuxième valeur limite de vieillissement (AG2) résulte d'un SoH actuel (IS) précédent par une étape de réduction prédéterminée.

6. Procédé de vieillissement selon la revendication 5, **caractérisé en ce que** l'étape de réduction prédéterminée diffère pour différents processus de vieillissement (AP1, AP2) et/ou pour différentes répétitions des boucles de vieillissement (AS1, AS2).

7. Procédé de vieillissement selon l'une quelconque des revendications précédentes, **caractérisé en ce qu'**au moins une des méthodes suivantes est utilisée lors de la détermination du SoH actuel (IS) :
- mesure de la capacité électrique de la cellule de batterie (100) raccordée,
- mesure de la résistance interne de la cellule de batterie (100) raccordée,
- introduction d'impulsions de puissance hybrides dans la cellule de batterie (100) raccordée.

8. Procédé de vieillissement selon l'une quelconque des revendications précédentes, **caractérisé en ce que**, dans la première boucle de vieillissement (AS1), le premier processus de vieillissement (AP1) et/ou, dans la deuxième boucle de vieillissement (AS2), le deuxième processus de vieillissement (AP2) est répété plusieurs fois avant que le référencement (R) soit réalisé.

9. Procédé de vieillissement selon l'une quelconque des revendications précédentes, **caractérisé en ce que** le premier processus de vieillissement (AP1) et/ou le deuxième processus de vieillissement (AP2) comprennent au moins l'une des étapes de processus de vieillissement suivantes :
- décharge de la cellule de batterie (100) raccordée jusqu'à un état de décharge défini,
- charge de la cellule de batterie (100) raccordée jusqu'à un état de charge défini,
- mise à température de la cellule de batterie (100) raccordée jusqu'à une température définie,
- réglage d'un courant de décharge défini pour la cellule de batterie (100) raccordée,
- réglage d'un courant de charge défini pour la cellule de batterie (100) raccordée,
- introduction d'une sollicitation mécanique dans la cellule de batterie (100) raccordée,
- limitation aux limites de fonctionnement dans le fonctionnement réel de la cellule de batterie (100) raccordée.

10. Procédé de vieillissement selon l'une quelconque des revendications précédentes, **caractérisé en ce que** le premier processus de vieillissement (AP1) et/ou le deuxième processus de vieillissement (AP2), notamment par sélection ciblée et ordre de succession d'étapes de processus de vieillissement, est spécifique à au moins l'un des types de vieillissement suivants :
- fonctionnement d'un véhicule en mode purement électrique,
- fonctionnement d'un véhicule en mode hybride rechargeable,
- vieillissement calendaire,
- fonctionnement en charge rapide,
- fonctionnement en charge lente.

11. Procédé de vieillissement selon l'une quelconque des revendications précédentes, **caractérisé en ce que** le premier processus de vieillissement (AP1) et/ou le deuxième processus de vieillissement (AP2), notamment par sélection ciblée et ordre de succession d'étapes de processus de vieillissement, sont adaptés à un profil d'utilisation prédéterminé de la cellule de batterie (100) raccordée dans un véhicule, notamment à au moins l'un des suivants :
- fonctionnement sur un circuit de course,
- utilisation de navetteur,
- utilisation sur courte distance,
- utilisation sur longue distance,
- utilisation avec une installation photovoltaïque.

12. Procédé de vieillissement selon l'une quelconque des revendications précédentes, **caractérisé en ce qu'**il est réalisé, pour au moins deux cellules de batterie (100) raccordées, au moins partiellement en parallèle dans le temps avec des boucles de vieillissement (AS1, AS2) identiques ou sensiblement identiques.

13. Procédé de vieillissement selon l'une quelconque des revendications précédentes, **caractérisé en ce qu'**il est réalisé, pour au moins deux cellules de batterie (100) raccordées, au moins partiellement en parallèle dans le temps avec des boucles de vieillissement (AS1, AS2) différentes.

14. Dispositif de vieillissement (10) destiné à la mise en œuvre d'un procédé de vieillissement pour un vieillissement accéléré spécifique à l'utilisation de cellules de batterie (100) sur un banc d'essai destiné à générer des informations d'étalonnage (KIN), comprenant un module de réception (20) destiné à la réception et au raccordement électrique d'au moins une cellule de batterie (100), le dispositif de vieillissement comprenant :
un module de référencement (30) destiné à réaliser un référencement (R) pour la détermination d'un SoH actuel (IS) d'une cellule de batterie (100) raccordée, un premier module de boucle (40) destiné à réaliser la première boucle de vieillissement (AS1), un deuxième module de boucle (50) destiné à réaliser une deuxième boucle de vieillissement (AS2) et un module de sortie (60) destiné à émettre des informations d'étalonnage (KIN), lesquelles comprennent des valeurs mesurées de la cellule de batterie (100) raccordée associées à au moins un des SoH actuels (IS) déterminés, le module de référencement (30), le premier module de boucle (40), le deuxième module de boucle (50) et/ou le module de sortie (60) étant conçus pour mettre en œuvre un procédé de vieillissement présentant les caractéristiques de l'une quelconque des revendications 1 à 13.

15. Produit de programme d'ordinateur comprenant des instructions qui, lorsqu'elles sont exécutées sur un ordinateur, amènent celui-ci à exécuter les étapes d'un procédé de vieillissement présentant les caractéristiques de l'une quelconque des revendications 1 à 13.
